# EUROPEAN PATENT SPECIFICATION

(11) **EP 0 609 241 B1**
(45) Date of publication and mention of the grant of the patent: **04.03.1998**
(21) Application number: 92919859.6
(22) Date of filing: 25.09.1992
(51) Int. Cl.: G03F 7/11, G03F 7/34, G03F 3/10

(54) **METHOD FOR PRODUCING IMAGES USING A PHOTOPOLYMERIZABLE COMPOSITION**
VERFAHREN ZUR ERZEUGUNG VON BILDERN UNTER VERWENDUNG EINER PHOTOPOLYMERISIERBARE ZUSAMMENSETZUNG
PROCEDE DE PRODUCTION D'IMAGES UTILISANT UNE COMPOSITION PHOTOPOLYMERISABLE

(30) Priority: 21.10.1991 EP 91202715
(43) Date of publication of application: 10.08.1994
(73) Proprietor: AGFA-GEVAERT N.V., 2640 Mortsel (BE)
(72) Inventor: UYTTERHOEVEN, Herman Jozef, B-2640 Mortsel (BE); PODSZUN, Wolfgang, B-2640 Mortsel (BE)
(86) International application number: EP9202239
(87) International publication number: WO9308508

(56) References cited:
- EP-A- 0 230 992
- FR-A- 2 510 276
- US-A- 3 260 612
- US-A- 3 387 974
- US-A- 3 622 320

## Description

### 1. Field of the invention.

The present invention relates to an imaging element comprising a photopolymerizable composition and a method for imaging said imaging element using a thermal transfer step.

### 2. Background of the invention.

The use of photopolymerizable compositions for the production of images by information-wise exposure thereof to actinic radiation is well known. Several methods for forming images using photopolymerizable compositions are known. All these methods are based on the principle of introducing a differentiation in properties between the exposed and non-exposed parts of the photopolymerizable composition e.g. a difference in solubility, adhesion, conductivity, refractive index, tackiness, permeability, diffusibility of incorporated substances e.g. dyes etc.. The thus produced differences may be subsequently employed in a developing step to produce a visible image and/or master for printing e.g. a lithographic or electrostatic printing master.

According to a method disclosed in US-P-3,060,023 the adhesion of the photopolymerizable composition is modified upon image-wise exposure. After image-wise exposure the non-exposed parts will stick or adhere, during a step of overall heating, to a receiving sheet thus allowing the transfer of the non-exposed parts to the receiving sheet.

In EP-A- 502,562 a method is disclosed for obtaining an image using an imaging element comprising a photopolymerizable composition on a transparant support and a porous layer of a color pigment. After information-wise exposure said imaging element is overall heated in contact with a receiving element e.g. paper or a polyester film so that the non-exposed or insufficiently exposed parts of the photopolymerizable composition are transferred together with the pigment layer at these parts to the receiving element.

According to this method black/white as well as color images of high resolution can be obtained. The thus transferred images are easily scratched so that the transferred photopolymerizable parts need to be hardened in a subsequent step of overall heating or exposure to actinic radiation. Probably due to the presence of color pigment in the transferred parts the hardening appears to be difficult and often incomplete so that the scratch and wear resistance of the image remains low.

US 3,387,974 discloses a transfer material having a porous overcoat on a photosensitive layer. FR 2510276 discloses a method for improving storage stability by a polyvinyl alcohol on top of a photopolymerizable composition.

### 3. Summary of the invention.

It is an object of the present invention to provide a method for obtaining an image with good scratch and wear resistance using an imaging element comprising on a support in the order given a layer containing a photopolymerizable composition and a porous layer containing pigments.

It is another object of the present invention to provide an imaging element for use in said method.

Further objects will become clear from the description hereinafter.

According to the invention an imaging element is provided comprising on a support in the order given a photosensitive layer containing a photopolymerizable composition and a porous layer containing pigments characterized in that non-exposed parts of the photosensitive layer upon heating the imaging element in contact with an image receiving element penetrate the overlying porous layer such that the parts of the porous layer overlying the non-exposed parts of the photosensitive layer are transferred together with the non-exposed parts of the photosensitive layer to the image receiving element and the weight ratio per unit area of the photosensitive layer to the porous layer is at least 2:1 exclusive of an imaging element consisting of a subbed polyethylene terephthalate support coated in the order given with:
(i) a base base layer of polyvinyl alcohol of which 25 mol% of hydroxy groups are modified with methacryloyl chloride to a thickness of 1g/m²;
(ii) a photosensitive layer having a thickness of 2g/m² and consisting of a polysiloxane polyether copolymer, bisimidazole, Michler's ketone, mercaptbenzoxazole, a compound according to formula (A) and a compound according to formula (B): 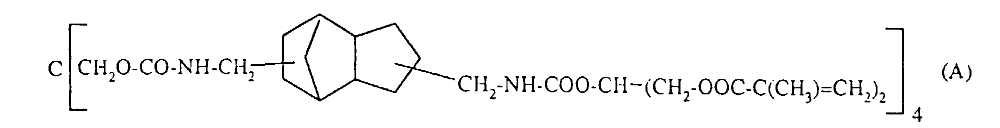 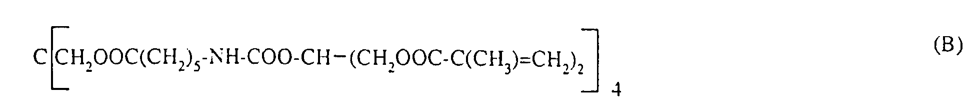
(iii) and a porous layer having a thickness of 0.5g/m² consisting of carbon black pigments or a combination of carbon black pigments and polyethylene latex particles.

According to the invention a method is provided for obtaining an image comprising the steps of:
- information-wise exposing to actinic radiation an imaging element comprising on a support in the order given a photosensitive layer containing a photopolymerizable composition and a porous layer containing pigments and wherein the weight ratio per unit area of the photosensitive layer to the porous layer is at least 2:1 exclusive of an imaging element consisting of a subbed polyethylene terephthalate support coated in the order given with:
   (i) a base base layer of polyvinyl alcohol of which 25 mol% of hydroxy groups are modified with methacryloyl chloride to a thickness of 1g/m²;
   (ii) a photosensitive layer having a thickness of 2g/m² and consisting of a polysiloxane polyether copolymer, bisimidazole, Michler's ketone, mercaptbenzoxazole, a compound according to formula (A) and a compound according to formula (B): 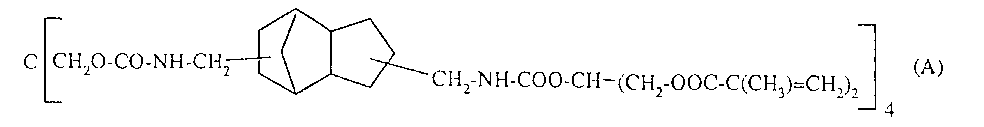 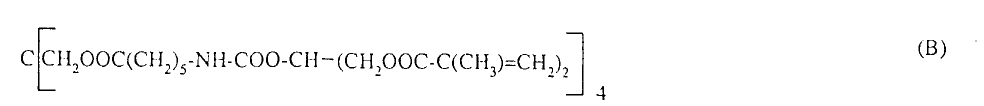
   (iii) and a porous layer having a thickness of 0.5g/m² consisting of carbon black pigments or a combination of carbon black pigments and polyethylene latex particles,
- heating the imaging element in contact with a receiving element whereupon non-exposed parts of the photosensitive layer are transferred to the image receiving element thereby penetrating the overlying porous layer,
- separating the imaging element and the receiving element whereupon the parts of the porous layer overlying the non-exposed parts of the photosensitive layer are transferred together with the non-exposed parts of the photosensitive layer to the image receiving element, and
- overall exposing the receiving element and said non-exposed parts of said photosensitive layer with said overlying parts of said porous layer transferred thereto to heat and/or actinic radiation.

### 4. Detailed description of the invention.

According to the present invention an imaging element comprising in the order given on a transparent support a photosensitive layer containing a photopolymerizable composition and a porous layer containing pigments is information-wise exposed to actinic radiation preferably through the back of the support, i.e. the side of the support opposite to the side containing the photosensitive layer, and subsequently heated in contact with an image receiving element so that the non-exposed parts of the photosensitive layer are transferred to the image receiving element thereby penetrating the overlying porous layer so that the parts of the porous layer overlying the non-exposed parts of the photosensitive layer are transferred together with the non-exposed parts of the photosensitive layer to the image receiving element. After the transfer the imaging element and receiving element are separated from each other and the receiving element is overall heated and/or exposed to actinic radiation to harden the transferred parts of the photosensitive layer. Alternatively the overall exposure may also be carried out while the imaging element and receiving element are still in contact with one each other. It has now been found that an image having a good scratch and wear resistance can be obtained according to the above method when the weight ratio per unit area of said photosensitive layer to said porous layer is at least 1:1, preferably at least 2:1. When said weight ratio is less than 1:1 the scratch and wear resistance is unsatisfactory.

The maximum weight ratio per unit area is not specifically limited and is determined by such factors as the absolute thickness of the photosensitive layer, composition of the photosensitive layer, composition and thickness of the porous layer, required sensitivety of the imaging element etc. A practical working range for said ratio is preferably between 1:1 and 10:1.

According to the present invention the thickness of the photosensitive layer is preferably between 0.25 pm and 10 pm while the thickness of the porous layer is preferably between 0.25 µm and 2 µm.

The photopolymerizable composition comprised in the photosensitive layer of the imaging element preferably contains urethane type monomers as disclosed in EP-A- 502.562 and the corresponding US-A No. 07/836,231 and DE-A-4129284.7 filed 3.9.91. These type of monomers offer the advantage that they show a rapid polymerization and solidify even at low conversions of less than 10%. Examples of urethane type monomers are:

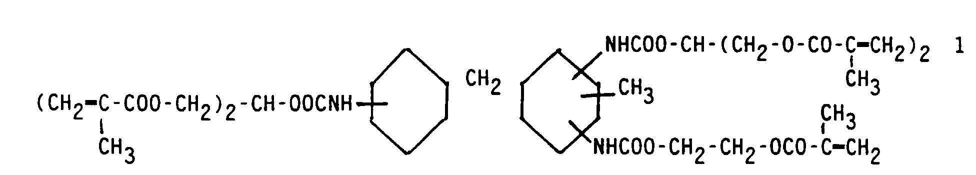

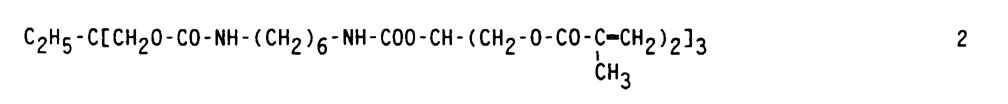

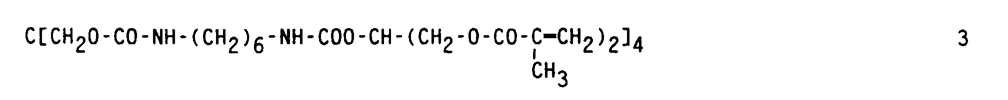

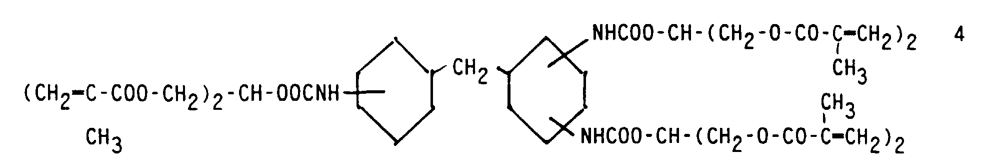

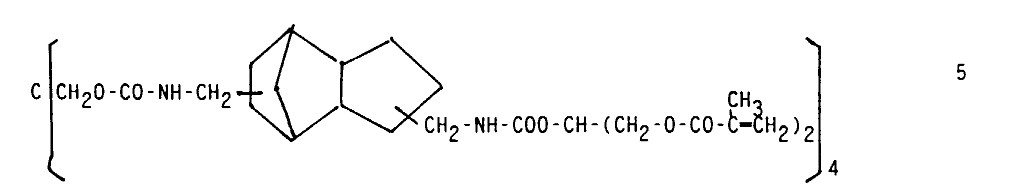

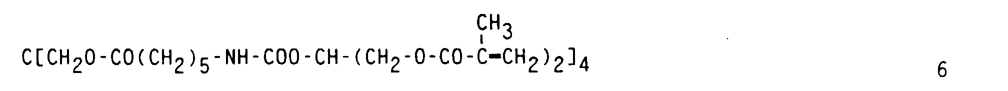

Other types of monomers suitable for use in the photopolymerizable composition used in accordance with the present invention are e.g. the monomers disclosed in DEOS no. 4,005,231, 3,516,256, 3,516,257 and 3,632,657, unsaturated esters of polyols, particularly such esters of the alpha-methylene carboxylic acids, e.g. ethylene diacrylate, glycerol tri(meth)acrylate, ethylene dimethacrylate, 1,3-propanediol di(meth)acrylate 1,2,4-butanetriol tri(meth)acrylate, 1,4-cyclohexanediol di(meth)acrylate, 1,4-benzenediol di(meth)acrylate, pentaerythritol tetra(meth)acrylate, 1,5-pentanediol di(meth)acrylate, the bis acrylates and methacrylates of polyethylene glycols of molecular weight 200-500, and the like : unsaturated amides, particularly those of the alphamethylene carboxylic acids. and especially those of alpha-omega-diamines and oxygen-interrupted omega-diamines, such as methylene bis-acrylamide, methylene bis-methacrylamide, 1,6-hexamethylene bis-acrylamide, diethylene triamine tris-methacrylamide, bis(gamma-methacrylamidopropoxy)ethane, beta-methacrylamidoethyl methacrylate, N-(beta-hydroxyethyl)-beta-(methacrylamido)ethyl acrylate and N,N-bis(beta-methacrylolyoxyethyl)acrylamide; vinyl esters e.g. divinyl succinate, divinyl adipate, divinyl phthalate, divinyl butane-1,4-disulfonate; and unsaturated aldehydes, e.g. sorbaldehyde (hexadienal). The photopolymerizable composition may also comprise polymers and/or oligomers comprising 2 or more polymerizable functions e.g. acrylated epoxies, polyester acrylates, urethane acrylates etc.. It will be clear that these monomers and/or polymers and/or oligomers can be used in admixture.

The photopolymerizable composition used in accordance with the present invention also comprises at least one photoinitiator. Preferably used photoinitiators are polymerization initiators activatable by actinic light and thermally inactive at and below 185°C. Examples of such initiators include the substituted or unsubstituted polynuclear quinones which are compounds having two intracyclic carbonyl groups attached to intracylic carbon atoms in a conjugated six-membered carbocyclic ring, there being at least one aromatic carbocyclic ring fused to the ring containing the carbonyl groups. Such initiators include 9-10-anthraquinone, 1-chloroanthraquinone, 2-chloroanthraquinone, 2-methylanthraquinone, 2-tert-butylanthraquinone. octamethylanthraquinone, 1,4-naphtoquinone, 9,10-phenanthrenequinone, 1-2 benzanthraquinone, 2,3-dichloronaphthoquinone, sodium salt of anthraquinone alpha-sulfonic acid, 3-chloro-2-methylanthraquinone, and 1,2,3,4-tetrahydrobenzene a anthracene-7,12-dione. The photointiators which are also useful are described in Plambeck U.S. Patent 2,760,863 and include vicinal ketaldonyl compounds, such as diacetyl, benzil, etc. alpha-ketaldonyl alcohols. such as benzoin, pivalon, etc. acyloin ethers e.g. benzoin methyl and ethyl ethers, etc.; alpha-hydrocarbon substituted aromatic acyloins, including mehtylbenzoin, alpha-allylbenzoin, and alpha-phenylbenzoin. Still further photoinitiators useful in accordance with the present invention are those disclosed in "Photoreactive Polymers" by Arnost Reiser, "Organic photochemical imaging systems" by G.A. Delzenne, in the paper "UV-Curing Chemistry: Past, Present, and Future" by Christian Decker, published in J. of Coatings Technology, Vol.59,N° 751, August 1987, pages 97-106, in EP-A 362,827, and in US-A 3,558,309.

To further improve the scratch and wear resistance of the transferred image it has been found that the weight ratio of photoinitiator to the polymerizable compound(s) of said photosensitive layer is preferably between 1:1 and 1:10.

According to the present invention thermal polymerization inhibitors may also be added to the photopolymerizable composition. Inhibitors for use in accordance with the present invention are p-methoxyphenol, hydroquinone, alkyl and acyl-substituted hydroquinones and quinones, tert-butylcatechol, pyrogallol, copper resinate, naphtylamines, beta-naphtol, cuprous chloride, Z,6-di-tert-butyl p-cresol, photothiazine. pyridine, nitrobenzene and dinitrobenzene, p-toluquinone and chloranil.

According to a preferred mode of the present invention the photosensitive layer containing the photopolymerizable composition is a thermoplastic layer comprising a thermoplastic polymer. Said thermoplastic layer is preferably solid at temperatures below 40°C and is transferable in the non-exposed or insufficiently exposed parts at temperatures between 40°C and 250°C.

Suitable thermoplastic polymers for use in accordance with the present invention include :
(A) Copolyesters, e.g. those prepared from the reaction product of an alkylene glycol e.g. polymethylene glycol of the formula HO(CH₂)ᵥOH, wherein v is a whole number 2 to 10 inclusive, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids.
(B) Nylons or polyamides, e.g. N-methoxymethyl polyhexamethylene adipamide;
(C) Vinylidene chloride copolymers. e.g. vinylidene chloride/acrylonitrile: vinylidene chloride/methylacrylate and vinylidene chloride/vinylacetate copolymers;
(D) Ethylene/vinyl acetate copolymer;
(E) Cellulosic ethers, e.g. methyl cellulose, ethyl cellulose and benzyl cellulose;
(F) Polyethylene;
(G) Synthetic rubbers, e.g. butadiene/acrylonitrile copolymers, and chloro-2-butadiene-1,3 polymers;
(H) Cellulose esters, e.g. cellulose acetate, cellulose acetate succinate and cellulose acetate butyrate, cellulose nitrate;
(I) Polyvinyl esters, e.g. polyvinyl acetate/acrylate, polyvinyl acetate/methacrylate and polyvinyl acetate;
(J) Poly(meth)acrylate and alpha-alkyl poly(meth)acrylate esters, e.g. polymethyl methacrylate and polyvinyl acetate;
(K) High molecular weight polyethylene oxides of polyglycols having average molecular weights from about 4,000 to 1,000,000;
(L) Polyvinyl chloride and copolymers, e.g. polyvinyl chloride/acetate, polyvinyl chloride/acetate/alkohol ;
(M) Polyvinyl acetal. e.g. polyvinyl butyral, polyvinyl formal;
(N) Polyformaldehydes:
(O) Polyurethanes and copolymers;
(P) Polycarbonate and copolymers;
(Q) Polystyrenes and copolymers e.g. polystyrene/acrylonitrile, polystyrene/acrylonitrile/butadiene.

To the thermoplastic polymer constituent of the photosensitive layer there can be added non-thermoplastic polymeric compounds to give certain desirable characteristics, e.g. to improve adhesion to the support or underlying layers used in accordance with the present invention, adhesion to the receptor support on transfer, wear properties, chemical inertness, etc. Suitable non-thermoplastic polymeric compounds include polyvinyl alcohol, cellulose, anhydrous gelatin, phenolic resins and melamine-formaldehyde resins, etc. If desired, the photopolymerizable layers can also contain immiscible polymeric or non-polymeric organic or inorganic fillers or reinforcing agents which are essentially transparent at the wave-lengths used for the exposure of the photopolymeric material, e.g. the organophilic silicas, bentonites, silica, powdered glass, colloidal carbon, as well as various types of dyes and pigments in amounts varying with the desired properties of the photopolymerizable layer. The fillers are useful in improving the strength of the composition, reducing tack and in addition, as coloring agents.

Agents to improve the wetting and/or adjust the adhesion of the thermoplastic layer may be added. Suitable agents are e.g. silicons, silicon containing polymers e.g. a poly(dimethylsiloxane)-polyether copolymer, poly(dimethylsiloxane)-polyester, silicon containing surfactants, fluor containing copolymers and fluor containing surfactants etc..

Various dyes, thermographic compounds. UV-absorbers, anti-oxidants and color forming components can be added to the photopolymerizable compositions to give a variety of results after the thermal transfer. These additive materials, however, preferably should not absorb excessive amounts of light at the exposure wavelength or inhibit the polymerization reaction.

Among the dyes useful in the invention are Fuchsine (C.I. 42510), Auramine Base (C.I. 410003), Calcocid Green S (C.I. 44000), Para Magenta (C.I. 42500). Tryparosan (C.I. 42505), New Magenta (C.I. 42520), Acid Violet RRL (C.I. 42425). Red Violet 5RS (C.I. 42960), C.I. Solvent Blue 36 (C.I. 61551). Nile Blue 2B (C.I. 51185), New Methylene BLue GG (C.I. 51195), C.I. Basic Blue 20 (C.I. 42585, Iodine Green (C.I. 42556), Night Green B (C.I. 42415), C.I. Direct Yellow 9 (C.I. 19540), C.I. Acid Yellow 17 (C.I. 18965), C.I. Acid Yellow 29 (C.I. 18900), Tartrazine (C.I. 19140), Supramine Yellow G (C.I. 19300), Buffalo Black 10B (C.I. 27790), Naphtalene Black 12R (C.I. 20350), Fast Black L (C.I. 51215), and Ethyl Violet (C.I. 42600).

Useful thermographic additives, e.g. 3 cyano-4.5-dimethyl-5-hydroxy-3-pyrrolin-2-one, and activators, e.g. copper acetate, are disclosed in the application of Holland and Wayrynen. Ser. No.807,761, filed April 21, 1959, and the following U.S. Patents : 2.825.494. 2,637.657, 2,665,654, 2,663,655, 2,663,656, and 2,663,657.

Suitable color-forming components which form colored compounds on the application of heat or when brought in contact with other color forming components in a receptor material are e.g.:
(1) Organic and inorganic components : dimethyl glyoxime and nickel salts; phenolphtalein and sodium hydroxide; starch/potassium iodide and oxidizing agent, i.e. peroxides, phenols and iron salts; thioacetamide and lead acetate, silver salt and reducing agent, e.g. hydroquinone.
(2) Inorganic components : ferric salts and potassium thiocyanate; ferrous salts and potassium ferricyanide; copper or silver salts and sulfide ions; lead acetate and sodium sulfide.
(3) Organic components : 2,4-dinitrophenylhydrazine and aldehydes or ketones; diazonium salt and phenol or naphtol, e.g. benzenediazonium chloride and B-naphtol; p-dimethylaminobenzaldehyde and p-diethylaminoaniline.

The porous layer used in connection with the present invention is preferably free of binder but may contain small amounts of binder as long as the layer remains sufficiently porous to allow penetration by the heated photosensitive layer. Preferably the amount of binder is less than 10 % by weight. Suitable pigments for use in said porous layer include, e.g. TiO₂, colloidal carbon, graphite, phosphor particles, ceramics, clays, metal powder such as aluminium, copper, magnetic iron and bronze, etc. The present invention is especially effective in case the porous layer contains colored pigments, i.e. pigments that absorb a substantial amount of actinic radiation that may be used for the curing of the transferred image.

According to a preferred mode of the present invention a base layer is provided between the support and the photosensitive layer. Said base layer preferably comprises a polymer containing polymerizable ethylenically unsaturated groups. Examples of polymers containing polymerizable ethylenically unsaturated groups for use in said base layer are polymers comprising vinyl groups, allyl groups, (meth)acrylate groups, butadiene groups, isoprene groups etc., e.g. acrylated epoxies, polyester acrylates, urethane acrylates etc.. It is however important with respect to the present invention that the base layer is sufficiently transparant to the radiation used for exposure of the photosensitive layer.

Suitable supports of the imaging element are supports that are transparant to the radiation used for exposing the imaging element and that are stable at the heating temperatures necessary for transfering the non-exposed or insufficiently exposed parts of the photopolymerizable composition to the receiving material. Examples of useful supports are e.g. polyester film supports e.g. polyethylene terephthalate, glass, cellulose esters e.g. cellulose acetate, cellulose propionate, cellulose butyrate, polycarbonate, polypropylene etc.

The support of the imaging element of the present invention preferably has a thickness of 3µm to 60µm. Such is important for contact exposures but is less important for exposures with lasers because the latter can be focussed in the photosensitive layer.

The receiving material to which the image is transferred must also be stable at the process temperature. The particular material used is dependant on the adhesion of the image to the support of the imaging element. Suitable receiving materials include paper, cardboard, metal sheets, foils and meshes e.g. aluminium, copper, steel, bronze etc., polyethylene, polyester film supports e.g. polyethylene terephthalate, opaque foamed or pigmented polyester, cellulose esters, silk, cotton, viscose rayon fabrics or screens, polycarbonate, polyvinyl chloride, polypropylene, polyethylene coated paper, supports provided with a thin metal layer e.g. polyester supports provided with a vapour deposited metal layer etc..

The surface of the receiving material may be a hydrophilic surface, a layer showing preferential adhesion towards the non-exposed parts of the layer containing the photopolymerizable composition or contain on its surface compounds that react with compounds being transferred so as to produce difference in color, hydrophilicity, conductivity etc. at the surface of the receiving material corresponding to the exposed and non-exposed parts.

The imaging element and receiving material may also be brought in contact before exposure or may together form an integral element. Such an element is called a monosheet material.

According to a practical embodiment of the present invention color images can be prepared. According to this embodiment at least three imaging elements comprising respectively a yellow, magenta and cyan dye or dye pigment in the porous layer overlying the photosensitive layer, are image-wise exposed corresponding to respectively the blue, green and red color selection of the original image. Optionally a fourth imaging element comprising a black dye or dye pigment in the porous layer can be used. Each of these imaging elements is successively heated in contact with the same receiving material e.g. a paper material to allow the transfer of each of the different color selections of the image. It is obvious that the transfer of the different color parts of the image must be carried out in register to obtain a faithful reproduction of the original image. The overall exposure to actinic radiation and/or heating according to the method of the present invention may be performed after each transfer step or only after the last color selection has been transferred.

According to a further embodiment of the present invention images can be obtained using a monosheet imaging element comprising on a transparant support in the order given an optional base layer as described above, a photosensitive layer, a porous layer containing pigment and a receiving layer. After information-wise exposure of the imaging element and subsequent development by means of heating the non-hardened or insufficiently hardened parts of the photosensitive layer will penetrate into the pigment layer and will be transferred together with said pigment layer to the receiving layer. The receiving layer is e.g. paper or polyester film. By the term transferred should be understood that the photosensitive layer together with the pigment layer adheres to the receiving layer. After the thermal transfer step the receiving layer is peeled apart from the imaging element and overall exposed to actinic radiation so that a clear image with good scratch and wear resistance is obtained. The overall exposure can also be carried out directly after the transfer step before separating the imaging element and receiving element.

According to a variant of the present embodiment a layer similar to the base layer described above may be provided between the pigment layer and the image receiving layer. After information-wise exposure and heat development the imaging element according to this variant is overall exposed to actinic radiation so that the transferred parts of the photosensitive layer are hardened and the adherence of the transferred parts to the image receiving material is enhanced which facilates their peeling apart. An image with good scratch and wear resistance is also obtained.

The present invention is illustrated by the following examples without however limiting it thereto. All parts are by weight unless otherwise specified.

### EXAMPLE 1 to 9

9 pairs of imaging elements were prepared as follows. A subbed polyethylene terephtalate support having a thickness of 100 µm was coated by means of a knife coater with a base layer of polyvinyl alcohol of which 25mol% of the hydroxyl groups were modified with methacryloyl chloride to a thickness of 1.15 g/m² (under dry conditions) and a layer comprising a photochemical imaging composition.

For the pairs of imaging elements 1 to 6 said layer containing said imaging composition was coated from a solution in methyl-ethyl keton of 4% of compound n° 2 mentioned above 0.2% by weight of a blue dye (C.I. 61551), 3.7% of bis-imidazole, 0.1% of Michler's keton and 0.2% of mercaptobenzoxazole. For the pairs of imaging elements 7 to 9 the concentration of compound n°2 was 8% instead of 4%. The weigth per unit area under dry conditions of the layer containing the photochemical imaging compositions for each of the pairs of imaging elements is given in table 1 below.

For each of the pairs of imaging elements the layer containing a photochemical imaging composition was overcoated with a 10% carbon black dispersion (Derusol™ C commercially available from Degussa A.G., Frankfurt, Germany) to an amount of 1g/m² for all the imaging elements except for the pair of example 7 that were coated to an amount of 2g/m².

Each of the thus obtained imaging elements was placed in contact with a test target and exposed therethrough to ultraviolet radiation and each was subsequently placed in face-to-face contact with a subbed polyethylene terephthalate support having a thickness of 100µm as the receiving element. The contacting elements were conveyed through a roll laminator device at 100°C and at a speed of 0.6 m/min. Next each of the contacting elements were peeled apart.

9 pairs of receiving elements carrying an image were thus obtained. For each pair one of the receiving elements was overall exposed to ultraviolet radiation using a Dupliphot™ apparatus (commercially available from Agfa-Gevaert) with an output of 300 illumination units and/or to heat by guiding the receiving element 10 times under an infrared lamp of 1200W at a distance of 1cm from said lamp and at a speed of 0.13m/s.

Each of the receiving elements was then subjected to a scratch test and a friction test. The scratch test was conducted by a diamant needle loaded with a weight of 15g. The friction test was conducted by rubbing 50 times the image on the receiving element with a stamper having a diameter of 5cm and covered with a paper foil. The evaluation for both tests was done visually and a number from 0 to 3 was given to indicate the resistance of the image against scratches and wear. A large number means a weak resistance.

**Table 1**

| Ex. no. | FP-layer (g/m²) | FP/C | ratio MFM/FI | scratch | wear |
|---|---|---|---|---|---|
| 1 A | 0.8 | 0.8 | 1 | 3 | 3 |
| 1 B | 0.8 | 0.8 | 1 | 3 | 2 |
| 2 A | 1.4 | 1.4 | 1 | 3 | |
| 2 B | 1.4 | 1.4 | 1 | 2 | |
| 3 A | 2.7 | 2.7 | 1 | 3 | |
| 3 B | 2.7 | 2.7 | 1 | 1 | |
| 4 A | 4.11 | 4.11 | 1 | 3 | |
| 4 B | 4.11 | 4.11 | 1 | 1 | |
| 5 A | 6.86 | 6.86 | 1 | 3 | 2 |
| 5 B | 6.86 | 6.86 | 1 | 0 | 1 |
| 5 C | 6.86 | 6.86 | 1 | 0 | 0 |
| 6 A | 1.85 | 1.85 | 2 | 3 | |
| 6 B | 1.85 | 1.85 | 2 | 1 | |
| 7 A | 3.69 | 1.85 | 2 | 3 | 3 |
| 7 B | 3.69 | 1.85 | 2 | 0 | 0 |
| 7 C | 3.69 | 1.85 | 2 | 0 | 1 |
| 8 A | 3.69 | 3.69 | 2 | 3 | |
| 8 B | 3.69 | 3.69 | 2 | 1 | |
| 8 C | 3.69 | 3.69 | 2 | 0 | |
| 9 A | 9.23 | 9.23 | 2 | 3 | 2 |
| 9 B | 9.23 | 9.23 | 2 | 0 | 0 |

In the above table 1 in each of the examples A represents an untreated sample, B represents a sample that has been overall exposed to U.V. radiation and C represents a sample overall exposed to U.V. and infrared radiation, FP represents the layer containing the photochemical composition. FP/C represents the weight ratio per unit area of the FP-layer to the layer containing carbon black, MFM represents the multi-functional monomer (compound no. 2) and FI represents the photoinitiator (Michler's keton, benzimidazole and mercaptobenzoxazole).

It can be seen from the above table 1 that overall exposure of the image to U.V. and/or infrared irradiation results in an improved scratch and wear resistance when the weight ratio per unit area of the layer containing the photochemical composition to the layer containing carbon black is at least 1:1. It can further be seen that an increase in the weight ratio multi-functional monomer to initiator also improves the scratch and wear resitance of the image.

## Claims

1. An imaging element comprising on a support in the order given a photosensitive layer containing a photopolymerizable composition and a porous layer containing pigments characterized in that non-exposed parts of said photosensitive layer upon heating said imaging element in contact with an image receiving element penetrate the overlying porous layer such that the parts of said porous layer overlying said non-exposed parts of said photosensitive layer are transferred together with said non-exposed parts of said photosensitive layer to said image receiving element and the weight ratio per unit area of said photosensitive layer to said porous layer is at least 2:1 exclusive of an imaging element consisting of a subbed polyethylene terephthalate support coated in the order given with:
(i) a base base layer of polyvinyl alcohol of which 25 mol% of hydroxy groups are modified with methacryloyl chloride to a thickness of 1g/m²:
(ii) a photosensitive layer having a thickness of 2g/m² and consisting of a polysiloxane polyether copolymer, bisimidazole, Michler's ketone, mercaptbenzoxazole, a compound according to formula (A) and a compound according to formula (B): 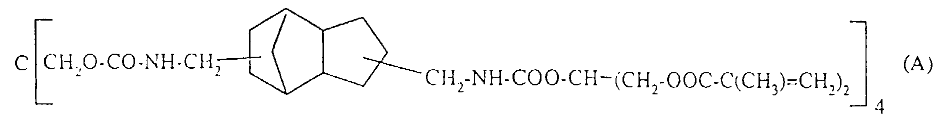 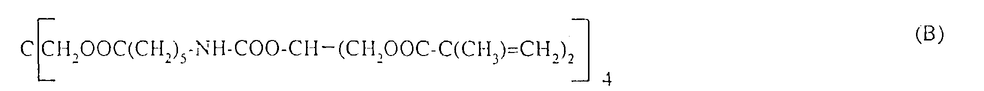
(iii) and a porous layer having a thickness of 0.5g/m² consisting of carbon black pigments or a combination of carbon black pigments and polyethylene latex particles.

2. An imaging element according to claim 1 wherein said photopolymerizable compostion comprises a photoinitiator and a compound having at least 2 polymerizable functions.

3. An imaging element according to claim 2 wherein the weight ratio of said compound having at least 2 polymerizable functions to said photoinitiator is between 1:1 and 10:1.

4. An imaging element according to any of the above claims wherein the thickness of said photosensitive layer is between 0.25µm and 10 µm and the thickness of said porous layer is between 0.25µm and 2µm.

5. An imaging element according to any of the above claims further comprising a base layer containing a polymer comprising ethylenically unsaturated groups between said support and said photosensitive layer.

6. An imaging element according to any of the above claims wherein said support is a polyester film support.

7. An imaging element according to any of the above claims wherein said support is transparent to actinic radiation used for exposing said imaging element and the thickness of said support is between 3µm and 60µm.

8. A method for obtaining an image comprising the steps of:
- information-wise exposing to actinic radiation an imaging element comprising on a support in the order given a photosensitive layer containing a photopolymerizable composition and a porous layer containing pigments and wherein the weight ratio per unit area of said photosensitive layer to said porous layer is at least 2:1 exclusive of an imaging element consisting of a subbed polyethylene terephthalate support coated in the order given with:
(i) a base base layer of polyvinyl alcohol of which 25 mol% of hydroxy groups are modified with methacryloyl chloride to a thickness of 1g/m²;
(ii) a photosensitive layer having a thickness of 2g/m² and consisting of a polysiloxane polyether copolymer, bisimidazole, Michler's ketone, mercaptbenzoxazole, a compound according to formula (A) and a compound according to formula (B): 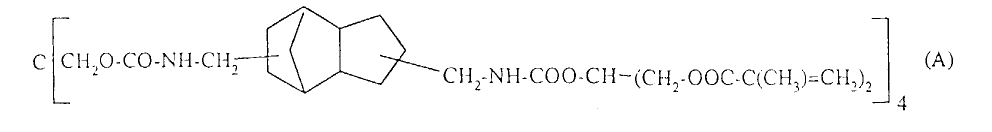 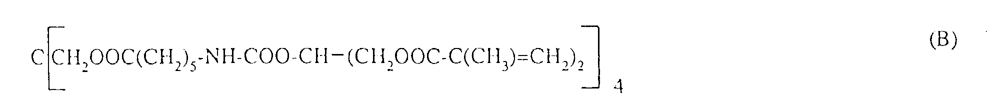
(iii) and a porous layer having a thickness of 0.5g/m² consisting of carbon black pigments or a combination of carbon black pigments and polyethylene latex particles,
- heating said imaging element in contact with a receiving element whereupon non-exposed parts of said photosensitive layer are transferred to the image receiving element thereby penetrating the overlying porous layer,
- separating said imaging element and said receiving element whereupon the parts of said porous layer overlying said non-exposed parts of said photosensitive layer are transferred together with said non-exposed parts of said photosensitive layer to said image receiving element, and
- overall exposing said receiving element and said non-exposed parts of said photosensitive layer with said overlying parts of said porous layer transferred thereto to heat and/or actinic radiation.

9. A method according to claim 8 wherein said imaging element and said receiving element are contacted before said information-wise exposure or form an integral element.

10. A method according to any of claims 8 or 9 wherein said receiving element is paper or a polyester film.

11. A method according to any of claims 8 to 10 wherein photopolymerizable composition comprises a photoinitiator and a compound having at least 2 polymerizable functions.

12. A method according to claim 11 wherein the weight ratio of said compound having at least 2 polymerizable functions to said photoinitiator is between 1:1 and 10:1.

13. A method according to any of claims 10 to 12 wherein the thickness of said photosensitive layer is between 0.25µm and 10µm and the thickness of said porous layer is between 0.25µm and 2µm.

14. A method according to any of claims 10 to 13 further comprising a base layer containing a polymer comprising ethylenically unsaturated groups between said support and said photosensitive layer.

15. A method according to any of claims 10 to 14 wherein said support is a polyester film support.

16. A method according to any of claims 10 to 15 wherein said support is transparent to actinic radiation used for exposing said imaging element and the thickness of said support is between 3µm and 60µm.

## Patentansprüche

1. Bilderzeugungselement, das auf einem Träger in der angegebenen Reihenfolge eine eine fotopolymerisierbare Zusammensetzung enthaltende, strahlungsempfindliche Schicht und eine Pigmente enthaltende poröse Schicht enthält, dadurch gekennzeichnet, daß beim Aufheizen des Bilderzeugungselements in Berührung mit einem Bildempfangselement nichtbelichtete Bereiche der strahlungsempfindlichen Schicht derart in die obenliegende poröse Schicht eindringen, daß diejenigen Bereiche der porösen Schicht, die über den nichtbelichteten Bereichen der strahlungsempfindlichen Schicht liegen, zusammen mit den nichtbelichteten Bereichen der strahlungsempfindlichen Schicht auf das Bildempfangselement übertragen werden, und dadurch gekennzeichnet, daß das Gewichtsverhältnis pro Oberflächeneinheit der strahlungsempfindlichen Schicht zu der porösen Schicht mindestens 2:1 beträgt, ausschließlich eines Bilderzeugungselements, das sich zusammensetzt aus einem substrierten Polyethylenterephthalatträger, der in der angegebenen Reihenfolge beschichtet wurde mit
(i) einer Grundierschicht aus Polyvinylalkohol, wovon 25 mol-% der Hydroxylgruppen mit Methacryloylchlorid modifiziert wurden, in einer Dicke von 1 g/m²;
(ii) einer strahlungsempfindlichen Schicht mit einer Dicke von 2 g/m², die sich aus einem Copolymeren aus Polysiloxan und Polyether, Bisimidazol, Michlerschem Keton, Merkaptobenzoxaxol, einer der Formel (A) entsprechenden Verbindung und einer der Formel (B) entsprechenden Verbindung zusammensetzt : 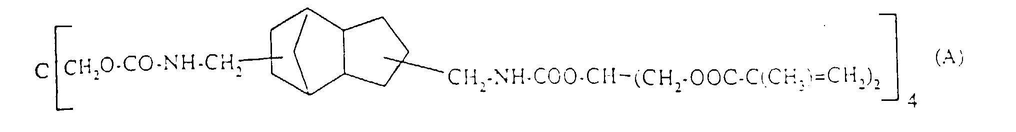 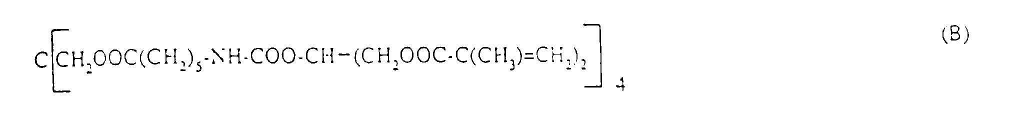
(iii) und einer porösen Schicht mit einer Dicke von 0,5 g/m², die sich aus Rußpigmenten oder einer Kombination von Rußpigmenten und Polyethylenlatexteilchen zusammensetzt

2. Bilderzeugungselement nach Anspruch 1, dadurch gekennzeichnet, daß diese fotopolymerisierbare Zusammensetzung einen Fotoinitiator und eine Verbindung mit wenigstens 2 polymerisierbaren Funktionen enthält.

3. Bilderzeugungselement nach Anspruch 2, dadurch gekennzeichnet, daß das Gewichtsverhältnis dieser Verbindung mit wenigstens 2 polymerisierbaren Funktionen zu diesem Fotoinitiator zwischen 1:1 und 10:1 liegt.

4. Bilderzeugungselement nach einem der vorhergehenden Ansprüche, dadurch gekennzeichnet, daß die Dicke dieser strahlungsempfindlichen Schicht zwischen 0,25 µm und 10 µm und die Dicke dieser porösen Schicht zwischen 0,25 µm und 2 µm liegt.

5. Bilderzeugungselement nach einem der vorhergehenden Ansprüche, das weiterhin eine Grundierschicht, die ein Polymeres mit ethylenisch ungesättigten Gruppen enthält, zwischen diesem Träger und dieser strahlungsempfindlichen Schicht enthält.

6. Bilderzeugungselement nach einem der vorhergehenden Ansprüche, dadurch gekennzeichnet, daß dieser Träger ein Polyesterfolienträger ist.

7. Bilderzeugungselement nach einem der vorhergehenden Ansprüche, dadurch gekennzeichnet, daß dieser Träger gegenüber der zur Belichtung dieses Bilderzeugungselements benutzten aktinischen Strahlung durchlässig ist und die Dicke dieses Trägers zwischen 3 µm und 60 µm liegt.

8. Verfahren zum Erhalten eines Bildes, das die folgenden Stufen umfaßt :
- informationsmäßige Belichtung mit aktinischer Strahlung eines Bilderzeugungselements, das auf einem Träger in der angegebenen Reihenfolge eine eine fotopolymerisierbare Zusammensetzung enthaltende, strahlungsempfindliche Schicht und eine Pigmente enthaltende poröse Schicht enthält, und wobei das Gewichtsverhältnis pro Oberflächeneinheit dieser strahlungsempfindlichen Schicht zu der porösen Schicht mindestens 2:1 beträgt, ausschließlich eines Bilderzeugungselements, das sich zusammensetzt aus einem substrierten Polyethylenterephthalatträger, der in der angegebenen Reihenfolge beschichtet wurde mit
(i) einer Grundierschicht aus Polyvinylalkohol, wovon 25 mol-% der Hydroxylgruppen mit Methacryloylchlorid modifiziert wurden, in einer Dicke von 1 g/m²;
(ii) einer strahlungsempfindlichen Schicht mit einer Dicke von 2 g/m², die sich aus einem Copolymeren aus Polysiloxan und Polyether, Bisimidazol, Michlerschem Keton, Merkaptobenzoxaxol, einer der Formel (A) entsprechenden Verbindung und einer der Formel (B) entsprechenden Verbindung zusammensetzt : 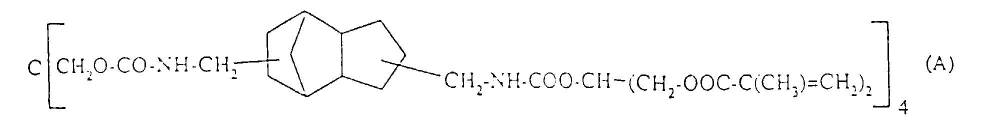 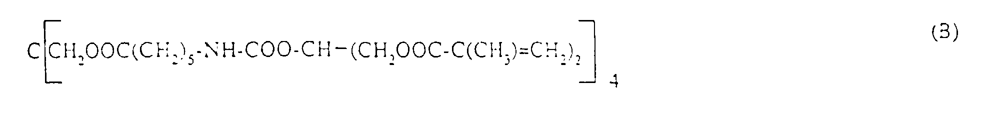
(iii) und einer porösen Schicht mit einer Dicke von 0,5 g/m², die sich aus Rußpigmenten oder einer Kombination von Rußpigmenten und Polyethylenlatexteilchen zusammensetzt,
- Aufheizen des Bilderzeugungselements in Berührung mit einem Empfangselement, worauf nichtbelichtete Bereiche der strahlungsempfindlichen Schicht auf das Bildempfangselement übertragen werden und somit in die obenliegende poröse Schicht eindringen,
- Trennen des Bilderzeugungselements vom Empfangselement, worauf diejenigen Bereiche der porösen Schicht, die über den nichtbelichteten Bereichen der strahlungsempfindlichen Schicht liegen, zusammen mit den nichtbelichteten Bereichen der strahlungsempfindlichen Schicht auf das Bildempfangselement übertragen werden, und
- gleichmäßige Belichtung mit Wärme und/oder aktinischer Strahlung des Empfangselements und der nichtbelichteten Bereiche der strahlungsempfindlichen Schicht mit den darauf übertragenen obenliegenden Bereichen der porösen Schicht.

9. Verfahren nach Anspruch 8, dadurch gekennzeichnet, daß dieses Bilderzeugungselement und dieses Empfangselement vor dieser informationmäßigen Belichtung miteinander in Berührung gebracht werden oder ein einteiliges Element bilden.

10. Verfahren nach einem der Ansprüche 8 oder 9, dadurch gekennzeichnet, daß dieses Empfangselement Papier oder eine Polyesterfolie ist.

11. Verfahren nach einem der Ansprüche 8 bis 10, dadurch gekennzeichnet, daß die fotopolymerisierbare Zusammensetzung einen Fotoinitiator und eine Verbindung mit wenigstens 2 polymerisierbaren Funktionen enthält.

12. Verfahren nach Anspruch 11, dadurch gekennzeichnet, daß das Gewichtsverhältnis dieser Verbindung mit wenigstens 2 polymerisierbaren Funktionen zu diesem Fotoinitiator zwischen 1:1 und 10:1 liegt.

13. Verfahren nach einem der Ansprüche 10 bis 12, dadurch gekennzeichnet, daß die Dicke dieser strahlungsempfindlichen Schicht zwischen 0,25 µm und 10 µm und die Dicke dieser porösen Schicht zwischen 0,25 µm und 2 µm liegt.

14. Verfahren nach einem der Ansprüche 10 bis 13, das weiterhin eine Grundierschicht, die ein Polymeres mit ethylenisch ungesättigten Gruppen enthält, zwischen diesem Träger und dieser strahlungsempfindlichen Schicht umfaßt.

15. Verfahren nach einem der Ansprüche 10 bis 14, dadurch gekennzeichnet, daß dieser Träger ein Polyesterfolienträger ist.

16. Verfahren nach einem der Ansprüche 10 bis 15, dadurch gekennzeichnet, daß dieser Träger gegenüber der zur Belichtung dieses Bilderzeugungselements benutzten aktinischen Strahlung durchlässig ist und die Dicke dieses Trägers zwischen 3 µm und 60 µm liegt.

## Revendications

1. Un élément formateur d'image comprenant sur un support - dans l'ordre donné - une couche photosensible contenant une composition photopolymérisable et une couche poreuse contenant des pigments, caractérisé en ce que des parties non exposées de la couche photosensible lors de l'échauffement de cet élément formateur d'image en contact avec un élément récepteur d'image pénètrent dans la couche poreuse située au-dessus, de façon à ce que les parties de la couche poreuse situées au-dessus des parties non exposées de la couche photosensible sont transférées ensemble avec les parties non exposées de la couche photosensible vers l'élément récepteur d'image et que le rapport pondéral par unité de surface entre la couche photosensible et la couche poreuse est au moins 2:1, à l'exclusion d'un élément formateur d'image composé d'un support substraté de poly(téréphtalate d'éthylène) enduit - dans l'ordre donné -:
(i) d'une couche de base basique d'alcool polyvinylique dont 25 mol-% de groupes hydroxyles sont modifiés avec du chlorure de méthacryloyle jusqu'à une épaisseur de 1 g/m²;
(ii) d'une couche photosensible avec une épaisseur de 2 g/m² et composée d'un copolymère de polysiloxane/polyéther, de bisimidazole, de cétone de Mischler, de mercaptobenzoxazole, d'un composé selon la formule (A) et d'un composé selon la formule (B): 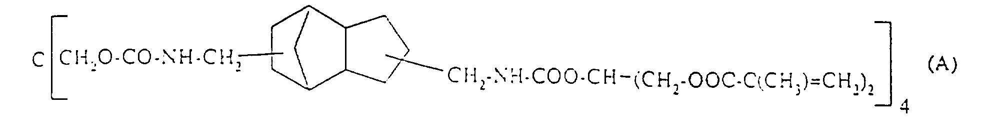 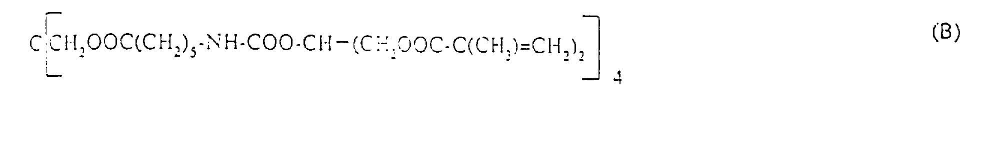
(iii) et une couche poreuse avec une épaisseur de 0,5 g/m² composée de pigments de noir de carbone ou d'une combinaison de pigments de noir de carbone et de particules de latex de polyéthylène.

2. Un élément formateur d'image selon la revendication 1, caractérisé en ce que ladite composition photopolymérisable comprend un photo-initiateur et un composé ayant au moins deux fonctions polymérisables.

3. Un élément formateur d'image selon la revendication 2, caractérisé en ce que le rapport pondéral entre ledit composé ayant au moins deux fonctions polymérisables et ledit photo-initiateur est situé entre 1:1 et 10:1.

4. Un élément formateur d'imag selon l'une quelconque des revendications précédentes, caractérisé en ce que l'épaisseur de ladite couche photosensible est entre 0,25 µm et 10 µm et que l'épaisseur de ladite couche poreuse est entre 0,25 µm et 2 µm.

5. Un élément formateur d'image selon l'une quelconque des revendications précédentes, comprenant en plus une couche de base contenant un polymère qui comprend des groupes éthyléniquement insaturés entre ledit support et ladite couche photosensible.

6. Un élément formateur d'image selon l'une quelconque des revendications précédentes, caractérisé en ce que ledit support est un support de film en polyester.

7. Un élément formateur d'image selon l'une quelconque des revendications précédentes, caractérisé en ce que ledit support est transparent au rayonnement actinique utilisé pour exposer ledit élément formateur d'image et que l'épaisseur dudit support se situe entre 3 µm et 60 µm.

8. Un procédé pour obtenir une image comprenant les phases suivantes:
- exposer sous forme d'information à un rayonnement actinique un élément formateur d'image comprenant sur un support - dans l'ordre donné - une couche photosensible contenant une composition photopolymérisable et une couche poreuse contenant des pigments et dans lequel le rapport pondéral par unité de surface entre la couche photosensible et la couche poreuse est au moins 2:1, à l'exclusion d'un élément formateur d'image composé d'un support substraté de poly(téréphtalate d'éthylène) enduit - dans l'ordre donné -:
(i) d'une couche de base basique d'alcool polyvinylique dont 25 mol-% de groupes hydroxyles sont modifiés avec du chlorure de méthacryloyle jusqu'à une épaisseur de 1 g/m²;
(ii) d'une couche photosensible avec une épaisseur de 2 g/m² et composée d'un copolymère de polysiloxane/polyéther, de bisimidazole, de cétone de Mischler, de mercaptobenzoxazole, d'un composé selon la formule (A) et d'un composé selon la formule (B): 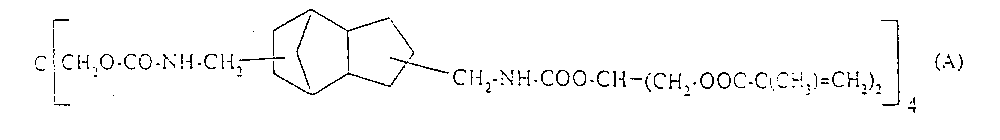 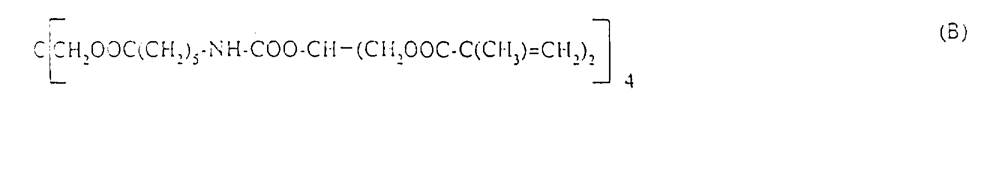
(iii) et une couche poreuse avec une épaisseur de 0,5 g/m² composée de pigments de noir de carbone ou d'une combinaison de pigments de noir de carbone et de particules de latex de polyéthylène,
- échauffer ledit élément formateur d'image en contact avec un élément récepteur, suite à quoi des parties non exposées de ladite couche photosensible sont transférées vers l'élément formateur d'image pénétrant ainsi dans la couche poreuse située au-dessus,
- séparer l'élément formateur d'image de l'élément récepteur d'image, suite à quoi les parties de la couche poreuse située au-dessus des parties non exposées de la couche photosensible sont transférées ensemble avec les parties non exposées de la couche photosensible vers l'élément récepteur d'image, et
- exposer intégralement à la chaleur et/ou à un rayonnement actinique l'élément récepteur et les parties non exposées de la couche photosensible avec les parties susjacentes de la couche poreuse qui y ont été transférées.

9. Un procédé selon la revendication 8, caractérisé en ce que l'élément formateur d'image et l'élément récepteur sont mis en contact avant qu'ils ne soient exposés sous forme d'information ou qu'ils ne forment un élément intégral.

10. Un procédé selon l'une quelconque des revendications 8 ou 9, caractérisé en ce que l'élément récepteur est du papier ou un film en polyester.

11. Un procédé selon l'une quelconque des revendications 8 à 10, caractérisé en ce que la composition photopolymérisable comprend un photo-initiateur et un composé ayant au moins 2 fonctions polymérisables.

12. Un procédé selon la revendication 11, caractérisé en ce que le rapport pondéral entre le composé ayant au moins 2 fonctions polymérisables et le photo-initiateur est entre 1:1 et 10:1.

13. Un procédé selon l'une quelconque des revendications 10 à 12, caractérisé en ce que l'épaisseur de la couche photosensible est entre 0,25 µm et 10 µm et que l'épaisseur de la couche poreuse est entre 0,25 µm et 2 µm.

14. Un procédé selon l'une quelconque des revendications 10 à 13, comprenant en plus une couche de base contenant un polymère comprenant des groupes éthyléniquement insaturés entre le support et la couche photosensible.

15. Un procédé selon l'une quelconque des revendications 10 à 14, caractérisé en ce que le support est un support de film en polyester.

16. Un procédé selon l'une quelconque des revendications 10 à 15, caractérisé en ce que le support est transparent au rayonnement actinique utilisé pour l'exposition de l'élément formateur d'image et que l'épaisseur du support est entre 3 µm et 60 µm.
